# EUROPEAN PATENT APPLICATION

(11) **EP 4 398 039 A1**
(43) Date of publication of application: **10.07.2024**
(21) Application number: 23740004.9
(22) Date of filing: 10.01.2023
(51) Int. Cl.: G03F 7/42, G03F 7/20, G03F 7/16

(54) **APPARATUS FOR SUBSTRATE PROCESSING**

(30) Priority: 14.01.2022 CN 202220092551 U
(71) Applicant: Contemporary Amperex Technology Co., Limited, Ningde, Fujian 352100 (CN)
(72) Inventor: LIU, Xiaosong, Ningde, Fujian 352100 (CN); LI, Keqiang, Ningde, Fujian 352100 (CN); WU, Zhiyang, Ningde, Fujian 352100 (CN); LU, Yi, Ningde, Fujian 352100 (CN)
(74) Representative: Laufhütte, Dieter
(86) International application number: PCT/CN2023/071530
(87) International publication number: WO 2023/134662

(57) **Abstract**

Embodiments of the present application disclose a substrate treatment apparatus, comprising: a coating device configured to coat a substrate, which is conveyed at a first speed in a feeding direction, with a material; a drying device configured to receive the substrate, which is coated by means of the coating device, at the first speed and dry the material; an exposure device configured to receive the substrate, which is dried by means of the drying device, at the first speed and continuously convey a mask at the first speed in the feeding direction, the mask being used for regional shading during exposure of the material by means of the exposure device, so that the material is subjected to continuous and regional exposure at the first speed by means of the exposure device; and an etching device configured to receive the substrate, which is exposed by means of the exposure device, at the first speed and etch the material and a portion of the substrate in an unexposed region of the substrate. According to the substrate treatment apparatus provided in the present application, the coating, drying, exposure and etching of the substrate can be carried out by one apparatus, thereby improving the substrate treatment efficiency.

## Description

### Cross-Reference to Related Application

The present patent document claims for the priority and benefit of Chinese patent application No. 202220092551.5, filed on January 14, 2022 and entitled "SUBSTRATE TREAMENT APPARATUS". The aforementioned patent application is incorporated herein by reference in its entirety as part of the disclosure of the present patent document.

### Technical Field

The present application relates to the field of substrate treatment, and in particular to a substrate treatment apparatus.

### Background Art

With the rapid development of electronic products, higher requirements have been put forward for electronic processing. In an etching process, which is one of the important processes in electronic processing, a base or a material coated on the base is selectively removed by means of physical or chemical methods so as to design various fine structures on the base.

In general, a substrate treatment process consists of coating, drying, exposure, developing and etching, which are respectively carried out by means of separate apparatuses such as a coater, a dryer and an exposure machine. These separate apparatuses cannot be integrated, and can neither control over the consistency of substrate treatment nor save on the time of transferring the substrate between the steps and the equipment cost, thus limiting the quality and efficiency of substrate treatment. Therefore, how to improve the substrate treatment efficiency is a problem to be solved.

### Summary

According to embodiments of the present application, there is provided a substrate treatment apparatus, by which the steps of coating, drying, exposure and etching for a substrate can be carried out by one apparatus, so that there is no need to transfer the substrate between the steps, thereby effectively improving the quality and efficiency of substrate treatment.

In a first aspect, there is provided a substrate treatment apparatus, including: a coating device configured to coat a substrate, which is conveyed at a first speed in a feeding direction, with a material; a drying device configured to receive the substrate, which is coated by means of the coating device, at the first speed and dry the material; an exposure device configured to receive the substrate, which is dried by means of the drying device, at the first speed and continuously convey a mask at the first speed in the feeding direction, the mask being used for regional shading during exposure of the material by means of the exposure device, so that the material is subjected to continuous and regional exposure at the first speed by means of the exposure device; and an etching device configured to receive the substrate, which is exposed by means of the exposure device, at the first speed and etch the material and a portion of the substrate in an unexposed region of the substrate.

In the embodiments of the present application, the exposure device can continuously convey the mask in the feeding direction, and during the exposure, the mask can move synchronously with the substrate in an exposure region, so that the substrate does not need to periodically stay in the exposure region. On this basis, the material can be conveyed to the devices at the same feeding speed and processed in the steps at the same feeding speed, and the exposure device, the coating device, the drying device and the etching device can be integrated into one apparatus to form an integrated apparatus, thereby saving on the time of transferring the substrate between the treatment steps during the substrate treatment process to improve the substrate treatment efficiency. In addition, the substrate treatment is implemented by means of the integrated apparatus, which is also conducive to saving on the equipment cost for transferring the substrate between the treatment steps.

In some embodiments, the apparatus further includes: a feeding device configured to convey the substrate at the first speed in the feeding direction.

In the embodiments of the present application, the substrate is continuously conveyed at the first speed by means of the feeding device, which facilitates controlling the movement conditions, such as the direction of movement and the speed of movement, of the substrate in the devices. This improves the consistency of movement of the substrate in the apparatus, and is conducive to improving the substrate treatment consistency and quality.

In some embodiments, the apparatus further includes: a cleaning device configured to receive the substrate, which is etched by means of the etching device, at the first speed and clean the substrate.

In the embodiments of the present application, the cleaning device can also be integrated in the substrate treatment apparatus to clean the etched substrate, so that the substrate output from the substrate treatment apparatus can be directly used, allowing the substrate treatment apparatus to have more functions and improving the performance of the substrate treatment apparatus.

In some embodiments, the coating device includes: a first feeding module configured to allow the feeding direction in the coating device to be a vertical direction.

In the embodiments of the present application, the coating device is provided with a first feeding module different from the feeding device, so that at least part of the substrate is in a vertical state in the coating device. The substrate is conveyed in the vertical direction in the coating device, which can make dust naturally fall off under gravity and reduce the dust attached to the material or the substrate, thereby improving the coating quality. In addition, the substrate is conveyed vertically during coating, so that the structure is compact, and the overall volume of the coating device can be reduced, thereby improving the space utilization of the substrate treatment apparatus.

In some embodiments, the coating device performs coating by means of a gravure coating process.

In the embodiments of the present application, by means of the gravure coating, the substrate can be uniformly and continuously coated with a thin layer of material, and the material has no defects such as adhesive residues and folds on the surface, which is conducive to improving the coating quality.

In some embodiments, the substrate has a first surface and a second surface opposite to the first surface, and the coating device is configured to coat the first surface and the second surface with the material.

In the embodiments of the present application, the coating device can coat the substrate on both sides at the same time, which improves the coating efficiency and is thus conducive to improving the substrate treatment efficiency.

In some embodiments, the drying device includes: a plurality of heating tubes and a plurality of air knives arranged at intervals on two sides of the substrate in the feeding direction.

In the embodiments of the present application, with the combination of the air knives and the heating tubes, the material coated on the substrate can be quickly dried for pre-curing of the material, and the substrate does not need to stay in the drying device, so that the drying device can cooperate with other devices to allow the substrate to always travel at the same feeding speed in the feeding direction, which facilitates integration of the apparatus.

In some embodiments, the exposure device includes: a mask conveying module configured to continuously convey the mask at the first speed in the feeding direction.

In the embodiments of the present application, the exposure device is provided with the mask conveying module that can continuously convey the mask. The mask is not fixed between a light source and the substrate, but passes through the exposure region together with the substrate at the same speed and in the same direction, so that the continuous exposure can be implemented. The substrate does not need to stay in the exposure region, so that the exposure device can cooperate with other devices to always convey the substrate at the same feeding speed in the feeding direction during the processing, which facilitates integration of the apparatus. Also, during the exposure, the mask always remains stationary relative to the substrate, which ensures that the pattern on the mask can be quickly and completely transferred to the substrate after exposure, achieving good pattern consistency. In addition, it is not necessary to make the direction of travel of the exposure pattern consistent with that of the substrate, so that the exposure device can perform continuous processing of a complex pattern, which improves the operation efficiency and performance of the exposure device and is thus conducive to improving the efficiency and performance of the substrate treatment apparatus.

In some embodiments, the mask is an endless mask, and the mask conveying module is configured to rotate the endless mask at the first speed.

In the embodiments of the present application, by means of the endless mask, the pattern on the mask can be used in cycles for exposure, which is conducive to improving the consistency of the exposure pattern, and the exposure device has a more compact structure, which is conducive to improving the space utilization of the substrate treatment apparatus.

In some embodiments, the mask conveying module includes: a first drive roller and a driven roller, the first drive roller rotating at the first speed as a linear velocity, and the first drive roller and the driven roller being disposed on the inside of the endless mask to rotate the endless mask.

In the embodiments of the present application, the mask conveying module rotates the mask by means of a structure of the drive roller and the driven roller, and can control the movement conditions of the mask by means of controlling the rotation speed and rotation direction of the drive roller and fix the movement path of the mask by means of the driven roller, so as to achieve flexible control of the mask to improve the flexibility of the exposure device, which is conducive to improving the treatment performance of the substrate treatment apparatus.

In some embodiments, the etching device includes: a conductive roller, a first electrode and an etching tank, the conductive roller and the first electrode being disposed in the etching tank, and the etching tank holding an electrolyte solution, where the conductive roller and the first electrode have opposite polarities, and the conductive roller comes into contact with the exposed substrate and conveys the substrate to the etching tank at the first speed.

In the embodiments of the present application, the etching device uses an electrochemical etching method, and can quickly etch the substrate and ensure that the substrate is subjected to etching while traveling at a certain speed, so that the substrate does not need to stay in the etching device, and thus the etching device can cooperate with other devices to allow the substrate to always travel at the same feeding speed in the feeding direction, which facilitates integration of the etching device with other devices.

In some embodiments, the cleaning device includes: a spray rod and a cleaning tank, the spray rod being configured to spray a cleaning liquid to the etched substrate, and the washing tank being configured to collect and discharge a waste liquid after cleaning the substrate.

In the embodiments of the present application, the cleaning device uses a combined structure of the spray rod and the cleaning tank, and can quickly clean the etched substrate to remove the residual material, etching liquid, etc. from the surface of the substrate, so that the substrate treatment apparatus can output substrates that can be directly used.

### Brief Description of the Drawings

To describe the technical solutions of the embodiments of the present application more clearly, the drawings required in the embodiments of the present application will be described briefly below. Obviously, the drawings illustrated below merely show some embodiments of the present application, and for those of ordinary skill in the art, other drawings can be obtained on the basis of these drawings without any creative efforts.
FIG. 1 is a schematic structural diagram of a vehicle according to the present application;
FIG. 2 is a schematic structural diagram of a battery according to the present application;
FIG. 3 is a schematic structural diagram of a substrate treatment apparatus according to the present application; and
FIG. 4 is a schematic structural diagram of a mask according to the present application.

### Detailed Description of Embodiments

The implementations of the present application will be further described in detail below with reference to the drawings and the embodiments. The following detailed description of the embodiments and the drawings are used to illustrate the principle of the present application by way of example and are not intended to limit the scope of the present application. That is, the present application is not limited to the described embodiments.

In the description of the present application, it should be noted that "multiple" means two or more, unless otherwise specified. The orientation or position relationship indicated by the terms "upper", "lower", "left", "right", "inner", "outer", etc. is only for the convenience of describing the present application and simplifying the description, rather than indicating or implying that the device or element referred to must have a particular orientation or be constructed and operated in a particular orientation, and therefore should not be construed as a limitation on the present application. In addition, the terms "first", "second", "third", etc. are merely for descriptive purposes, and should not be construed as indicating or implying the relative importance. The term "perpendicular" does not mean being perpendicular in the strict sense, but within an allowable range of tolerance. The term "parallel" does not mean being parallel in the strict sense, but within an allowable range of tolerance.

The orientation terms in the following description all indicate directions shown in the drawings, but do not limit the specific structure in the present application. In the description of the present application, it should also be noted that the terms "mount", "couple" and "connect" should be interpreted in a broad sense. For example, the connection may be a fixed connection, a detachable connection or an integral connection; or may be a direct connection, or may be an indirect connection by means of an intermediate medium. For those of ordinary skill in the art, the specific meanings of the foregoing terms in the present application can be construed according to specific circumstances.

The term "and/or" in the present application is merely intended to describe the associated relationship of associated objects, indicating that three relationships may exist. For example, A and/or B, may indicate: only A exists, both A and B exist, and only B exists. In addition, the character "/" in the present application generally indicates an "or" relationship between the associated objects.

Unless otherwise defined, all technical and scientific terms used in the present application have the same meanings as those commonly understood by those skilled in the art to which the present application belongs. The terms used in the specification of the present application are merely for the purpose of describing specific embodiments, but are not intended to limit the present application. The terms "include/comprise" and "has/have" and any variations thereof in the specification and the claims of the present application and in the foregoing brief description of the drawings are intended to cover non-exclusive inclusions. The terms "first", "second", etc. in the specification and the claims of the present application and in the foregoing drawings are used to distinguish different objects, rather than describing a specific order or a primary-secondary relationship.

The phrase "embodiment" mentioned in the present application means that the specific features, structures and characteristics described with reference to the embodiment may be encompassed in at least one embodiment of the present application. The phrase at various locations in the specification does not necessarily refer to the same embodiment, or an independent or alternative embodiment exclusive of other embodiments. Those skilled in the art should understand explicitly or implicitly that the embodiments described in the present application can be combined with other embodiments.

In actual production and life, to improve the stability of an active substance layer on a surface of a current collector and increase the loading of active substances on the surface of the current collector, the current collector is generally designed and processed to form some microstructures, such as recesses, through holes, etc. on the surface. In general, during processing, a surface of a current collector is coated with photoresist, is covered with a processed mask, and is then subjected to exposure by means of an exposure source, and then after the patterned photoresist on the mask is developed, the current collector is etched to form microstructures on the surface of the current collector.

During the processing described above, in the exposure device, the mask is generally fixed between a light source and the current collector, and the current collector is generally a continuous copper foil strip or aluminum foil strip, which is coated with photoresist on the surface and can be continuously conveyed relative to the light source and the mask. In the exposure process of the current collector, since the mask and the light source are fixed in position, the current collector needs to stay in an exposure region during exposure and wait for exposure, and a feeding device needs to be started after the exposure such that the exposed current collector is transferred while the unexposed current collector is continued to be conveyed to the exposure region, so that the current collector needs to periodically stay in the exposure region, and the light source also needs to periodically start for exposure. Thus, the material cannot continuously move at a uniform speed in the exposure device, so that the exposure device cannot be integrate with the coating device, the drying device and other devices. As a result, multiple separate devices are required for the processing of the current collector, which results in high equipment cost and cannot save on the time cost of transferring the current collector between the multiple devices, thus limiting the processing efficiency of the current collector. In addition, the current collector is processed by multiple separate devices, which cannot achieve high consistency.

In view of this, the present application provides a substrate treatment apparatus, by which the steps of coating, drying, exposure and etching for a substrate can be carried out by one apparatus, so that there is no need to transfer the substrate between the steps, thereby effectively improving the quality and efficiency of substrate treatment.

It should be understood that the processing of the current collector is taken as an example in the embodiments of the present application, and the substrate treatment apparatus provided in the embodiments of the present application can be used for, but is not limited to, manufacturing of current collectors. The apparatus can also be used for pattern processing operations in the fields such as display panels, integrated circuits and semiconductors, and can also improve the substrate treatment efficiency.

In recent years, batteries as a major power device have been widely used in many fields such as electronic devices, electric bicycles, electric motorcycles, electric vehicles, military equipment, and aerospace.

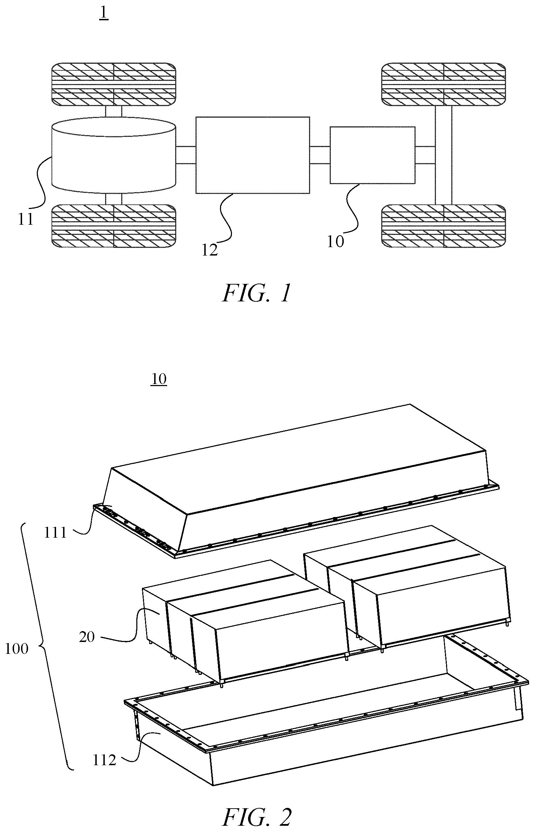

For example, FIG. 1 shows a schematic structural diagram of a vehicle 1 according to the present application. The vehicle 1 may be a fuel vehicle, a gas vehicle or a new-energy vehicle. The new-energy vehicle may be a battery electric vehicle, a hybrid vehicle, an extended-range vehicle, etc. A motor 11, a controller 12 and a battery 10 may be provided inside the vehicle 1. The controller 12 is configured to control the battery 10 to supply power to the motor 11. For example, the battery 10 may be arranged at the bottom, the front or the rear of the vehicle 1. The battery 10 may be configured to supply power to the vehicle 1. For example, the battery 10 may serve as an operating power supply for the vehicle 1 for use in a circuit system of the vehicle 1 to meet, for example, the operating power demand during the startup, navigation and traveling of the vehicle 1. In another embodiment of the present application, the battery 10 may not only serve as an operation power supply for the vehicle 1, but may also serve as a driving power supply for the vehicle 1, in place of or partially in place of fuel or natural gas, to supply driving power to the vehicle 1.

In the present application, a battery refers to a physical module including one or more battery cells to supply electric energy. For example, the battery mentioned in the present application may include a battery module, a battery pack, etc. The battery generally includes a case for packaging one or more battery cells. The case can prevent liquid or other foreign matters from affecting charging or discharging of the battery cell(s).

The battery may include a plurality of battery cells in order to meet different power demands, with the plurality of battery cells being in series connection, in parallel connection, or in series-parallel connection. The series-parallel connection refers to a combination of series connection and parallel connection. The battery may also be referred to as a battery pack. Optionally, multiple battery cells may be in series connection, in parallel connection or in series-parallel connection to constitute a battery module, and then multiple battery modules may be in series connection, in parallel connection or in series-parallel connection to constitute the battery. That is, multiple battery cells may directly form a battery; or multiple battery cells may form a battery module first, and then the battery modules may form a battery.

For example, FIG. 2 shows a schematic structural diagram of a battery 10 according to the present application. The battery 10 may include multiple battery cells 20. The number of the battery cells 20 may be set as any value. The multiple battery cells 20 may be in series connection, in parallel connection or in series-parallel connection to achieve high capacity or power.

Optionally, the battery cell 20 may be a lithium ion secondary battery, a lithium ion primary battery, a lithium-sulfur battery, a sodium/lithium ion battery, a sodium ion battery, a magnesium ion battery, etc., which is not limited in the embodiments of the present application. In some embodiments, the battery cell 20 may also be referred to as a cell.

The battery cell 20 includes an electrode assembly and an electrolytic solution. The electrode assembly is composed of a positive electrode plate, a negative electrode plate and a separator. The operation of the battery cell mainly relies on the movement of metal ions between the positive electrode plate and the negative electrode plate. The positive electrode plate includes a positive current collector and a positive active material layer. The positive active material layer is coated on a surface of the positive current collector, and the current collector not coated with the positive active material layer protrudes from the current collector coated with the positive active material layer and serves as a positive electrode tab. Taking a lithium ion battery as an example, the positive current collector may be made of aluminum, and the positive active material may be lithium cobalt oxide, lithium iron phosphate, ternary lithium, lithium manganate, etc. The negative electrode plate includes a negative current collector and a negative active material. The negative active material is coated on a surface of the negative current collector, and the current collector not coated with the negative active material protrudes from the current collector coated with the negative active material and serves as a negative electrode tab. The negative current collector may be made of copper, and the negative electrode active material may be carbon, silicon, etc. In order to ensure that no fusing occurs when a large current passes, multiple positive electrode tabs are provided and are stacked together, and multiple negative electrode tabs are provided and are stacked together. The separator may be made from polypropylene (PP), polyethylene (PE) or the like. In addition, the electrode assembly may be of a wound structure or a laminated structure, which will not be limited in the embodiments of the present application.

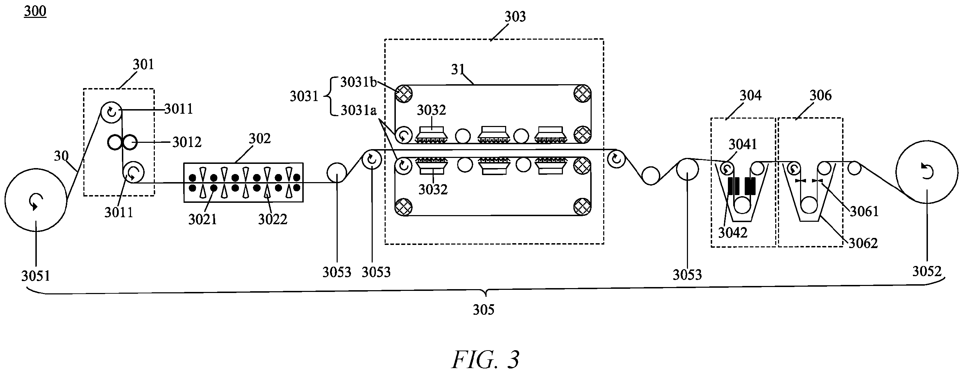

FIG. 3 is a schematic structural diagram of a substrate treatment apparatus 300 according to the present application. The substrate treatment apparatus 300 includes the following devices.

A coating device 301 is configured to coat a substrate 30, which is conveyed at a first speed in a feeding direction, with a material.

A drying device 302 is configured to receive the substrate 30, which is coated by means of the coating device 301, at the first speed and dry the material.

An exposure device 303 is configured to receive the substrate 30, which is dried by means of the drying device 302, at the first speed and continuously convey a mask 31 in the feeding direction at the first speed, the mask 31 being used for regional shading during exposure of the material by means of the exposure device 303, so that the material is subjected to continuous and regional exposure at the first speed by means of the exposure device 303.

An etching device304 is configured to receive the substrate 30, which is exposed by means of the exposure device 303, at the first speed and etch the material and a portion of the substrate 30 in an unexposed region of the substrate.

Specifically, in the apparatus 300, the substrate 30 travels in the devices at the same speed in the feeding direction. Especially in the exposure device 303, since the exposure device 303 can continuously convey the mask 31 in the feeding direction, during the exposure, the mask 31 can move synchronously with the substrate 30 in an exposure region, so that the substrate does not need to periodically stay in the exposure region. The synchronous movement means that the mask 31 remains stationary relative to the substrate 30 in the exposure region.

During the processing of the current collector, the material coated on the substrate is photoresist. Photoresist, also referred to as photo-resist, refers to a thin etch-resist material whose solubility changes due to irradiation or radiation by ultraviolet light, electron beam, ion beam, X-ray, etc. Photoresist may be a light-sensitive mixed liquid mainly composed of photosensitive resin, a sensitizer and a solvent. Using an appropriate selective photoresist, it is possible to obtain a desired pattern on the surface. During the exposure, by means of light irradiation, the pattern on the mask 31 is projected onto the photoresist through an optical system so as to achieve transfer of the pattern.

In some embodiments, after the photoresist is subj ected to exposure and development, the exposed portion of the photoresist is dissolved, while the unexposed portion remains, and this type of photoresist is a positive photoresist. In other embodiments, after the photoresist is subjected to exposure and development, the exposed portion remains, while the unexposed portion is dissolved, and this type of photoresist is a negative photoresist.

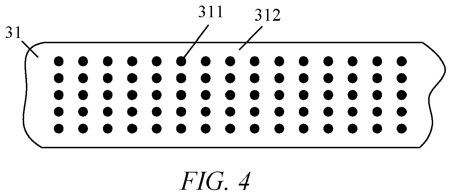

FIG. 4 is a schematic structural diagram of a mask 31 according to an embodiment of the present application. The mask 31 has light-shielding portions 311 and a light-transmitting portion 312, and the light-shielding portions 311 and/or the light-transmitting portion 312 constitute an exposure pattern on the mask 31.

The light portion 311 shown in FIG. 4 is round, and multiple light-shielding portions 311 are arranged in a rectangular array. In some embodiments, the light-shielding portion 311 may also be in other shapes, and the shape, number and arrangement of the light-shielding portions 311 or the light-transmitting portion 312 can be set according to the actual processing needs, which will not be limited in the present application.

For the exposure device 303 provided in this embodiment of the present application, if the photoresist is a positive photoresist, the portion of the photoresist that is irradiated by the light transmitting through the light-transmitting portion 312 is dissolved so as to form a pattern in the shape consistent with the shape of the light-transmitting portion 312, and the portions of the photoresist corresponding to the light-shielding portions 311 remain. If the photoresist is a negative photoresist, the portion of the photoresist that is irradiated by the light transmitting through the light-transmitting portion 312 remains, and the portions of the photoresist corresponding to the light-shielding portions 311 are dissolved so as to form a pattern in the shape consistent with the shape of the light-shielding portions 311. After the exposure and development, the portion of the substrate 30 having no photoresist is etched in the etching device, so as to form a pattern corresponding to the light-shielding portions 311 or the light-transmitting portion 312 on the surface of the substrate.

In this embodiment, the material 30 can be conveyed to the devices at the same feeding speed and processed in the steps at the same feeding speed, so that the exposure device 303, the coating device 301, the drying device 302 and the etching device 304 can be integrated into one apparatus to form an integrated apparatus 300, thereby saving on the time of transferring the substrate 30 between the treatment steps in the treatment process of the substrate 30 to effectively improve the treatment efficiency of the substrate 30. In addition, the substrate 30 is treated by means of the integrated apparatus, which is also conducive to saving on the equipment cost of transferring the substrate 30 between the treatment steps.

Optionally, the apparatus 300 further includes a feeding device 305 configured to convey the substrate 30 at the first speed in the feeding direction.

Optionally, in an embodiment, the feeding device may be of a roll-to-roll structure, with continued reference to FIG. 3. The feeding device 305 includes an unwinding roller 3051, a winding roller 3052, and a guide roller 3053 disposed between the unwinding roller 3051 and the winding roller 3052. There is a roll of untreated substrate 30 on the discharge roller 3051, and the untreated substrate 30 can be released with rotation of the discharge roller 3051; and the treated substrate 30 can be collected and wound into a roll with the rotation of the receiving roller 3052 to facilitate use. Optionally, the feeding device 305 further includes multiple guide rollers 3053 which are disposed between the unwinding roller 3051 and the winding roller 3052 for supporting the substrate 30 and driving the substrate 30 such that the substrate 30 is conveyed along the path of arrangement of the guide rollers 3053.

It should be understood that the feeding device 305 in this embodiment of the present application is of, for example, but not limited to, a roll-to-roll structure. For example, the feeding device 305 may also be in the form of a clamping and feeding mechanism having a manipulator, etc.

In this embodiment, the substrate 30 is continuously conveyed at the first speed by means of the feeding device 305, which facilitates controlling the movement conditions, such as the direction of movement and the speed of movement, of the substrate 30 in the devices. This can improve the consistency of movement of the substrate 30 in the apparatus 300 while flexibly controlling the movement conditions of the substrate, which is conducive to improving the treatment consistency and quality of the substrate 30.

Optionally, the apparatus 300 further includes a cleaning device 306 configured to receive the substrate, which is etched by means of the etching device, at the first speed and clean the substrate.

Specifically, after the substrate 30 is etched by means of the etching device, there are waste and other contaminants attached to the surface. The cleaning device 306 is provided after the etching device 304, and can quickly remove the contaminants from the surface of the substrate 30, so that the substrate 30 output from the apparatus 300 can be directly used, allowing the apparatus 300 to have more functions and improving the performance of the apparatus 300.

Optionally, the cleaning device 306 includes a spray rod 3061 and a cleaning tank 3062. The spray rod 3061 is configured to spray a cleaning liquid to the etched substrate 30, and the washing tank 3062 is configured to collect and discharge a waste liquid after cleaning the substrate 30.

Specifically, multiple spray rods 3061 may be provided and respectively disposed on two sides of the substrate 30; and the cleaning tank 3062 is disposed below the spray rod 3061 and the substrate 30. In a preferred embodiment, the cleaning device 306 includes four spray rods 3061, and the four spray rods 3061 are oppositely disposed in pairs on the two sides of the substrate 30.

In this embodiment, the cleaning device 306 uses a combined structure of the spray rod 3061 and the cleaning tank 3062, and can quickly clean the etched substrate 30 to remove the residual material, etching liquid and other contaminants from the surface of the substrate 30, so that the apparatus 300 outputs the substrate 30 that can be directly used.

Optionally, the coating device 301 includes a first feeding module 3011. By means of the first feeding module 3011, the feeding direction is a vertical direction in the coating device 301.

Specifically, the first feeding module 3011 has two feeding rollers arranged in the value direction, so that the substrate 30 located between the two feeding rollers is conveyed in the vertical direction.

In this embodiment, by means of the first feeding module 3011 of the coating device 301, at least part of the substrate 30 is in a vertical state in the coating device 30, which can make dust naturally fall off under gravity and reduce the dust attached to the material or the substrate 30, thereby improving the coating quality. In addition, the substrate 30 is conveyed vertically during coating, so that the structure is compact, and the overall volume of the coating device 301 can be reduced, thereby improving the space utilization of the apparatus 300.

Optionally, the coating device 301 performs coating by a gravure coating process.

Specifically, the coating device 301 is also provided with a coating roller 3012. The coating roller 3012 is located between the two feeding rollers of the first feeding module 3011, and is configured to coat the substrate 30 in the vertical state with the material. The surface of the coating roller 3012 has a textured structure, the coating roller 3012 is partially immersed in a material tray, and during coating, the coating roller 3012 rotates to move the material such that the material passes through a flexible scraper and is then taken away by the reversely moving substrate 30 so as to coat the substrate 30 with a layer of material.

In this embodiment, by means of the gravure coating, the substrate can be uniformly and continuously coated with a thin layer of material, and the material has no defects such as adhesive residues and folds on the surface, which is conducive to improving the coating quality.

Optionally, the substrate 30 has a first surface and a second surface opposite to the first surface. The coating device 301 is configured to coat the first surface and the second surface with the material. Specifically, the coating rollers 3012 may be disposed oppositely on the two sides of the material and can coat the substrate 30 with the material on the two sides at the same time, which is conducive to improving the stability of the substrate 30 during coating.

Optionally, in an embodiment, the coating device 301 is further provided with a back roller (not shown in the figure). When the coating device 301 only includes one coating roller 3012, the back roller may be provided on the other side of the substrate 30 at a position corresponding to the coating roller 3012, which is conducive to improving the stability of the substrate 30 during coating to improve the coating effect.

In the embodiments of the present application, the coating device 301 can coat the substrate 30 on the two sides at the same time, which improves the coating efficiency and is thus conducive to improving the treatment efficiency of the substrate 30.

Optionally, the drying device 302 includes multiple heating tubes 3021 and multiple air knives 3022. The multiple heating tubes 3021 and multiple air knives 3022 are disposed at intervals on the two sides of the substrate 30 in the feeding direction.

The arrangement of the multiple heating tubes 3021 and the multiple air knives 3022 at intervals means that, on each side of the substrate 30, the heating tubes 3021 and the air knives 3022 are spaced apart from each other, with one air knife 3022 being provided between two adjacent heating tubes 3021, and one heating tube 3021 being provided between two adjacent air knives 3022. It should be understood that, in some other embodiments, the number and arrangement of the heating tubes 3021 and the air knives 3022 can be configured according to the drying speed, feeding speed, etc. required for processing the substrate 30. For example, three heating tubes 3021 are provided between two adjacent air knives 3022.

In this embodiment, with the combination of the air knives 3022 and the heating tubes 3021, the material coated on the substrate 30 can be quickly dried for pre-curing of the material, and the substrate 30 does not need to stay in the drying device 302, so that the drying device 302 can cooperate with other devices to allow the substrate 30 to always travel at the same feeding speed in the feeding direction, which facilitates integration of the apparatus 300.

Optionally, the exposure device303 includes a mask conveying module 3031. The mask conveying module 3031 is configured to continuously convey the mask 31 at the first speed in the feeding direction.

Specifically, the exposure device 303 is provided with a light source 3032 that can emit light in the UV band to the material, the light emitted by the light source 3032 irradiates the substrate 30 to form a corresponding exposure region in which the light emitted by the exposure device 303 is blocked by the mask 31, so that part of the light transmits through the mask 31 and reaches the surface of the substrate 30 to interact with the photoresist. During the exposure, the substrate 30 and the mask 31 move at the same speed in the same direction in the exposure region, that is, the substrate 30 and the mask 31 move synchronously in the exposure region.

In this embodiment, the exposure device 303 is provided with a mask conveying module 3031 that can continuously convey the mask 31. The mask 31 is not fixed between a light source 3032 and the substrate 30, but passes through the exposure region together with the substrate 30 at the same speed and in the same direction so as to achieve continuous exposure, so that the substrate 30 does not need to stay in the exposure region, and thus the exposure device 303 can cooperate with other devices to always convey the substrate 30 at the same feeding speed in the feeding direction during the processing, which facilitates integration of the apparatus. Also, during the exposure, the mask 31 always remains stationary relative to the substrate 30, which ensures that the pattern on the mask 31 can be quickly and completely transferred to the substrate 30 after exposure, achieving good pattern consistency. In addition, it is not necessary to make the direction of travel of the exposure pattern consistent with that of the substrate 30, so that the exposure device 303 can perform continuous processing of a complex pattern, which improves the operation efficiency and performance of the exposure device 303 and is thus conducive to improving the efficiency and performance of the apparatus 300.

Optionally, the mask 31 is a strip-shaped mask, and the mask conveying module 3031 is configured to convey the strip-shaped mask to the exposure region at the first speed.

Specifically, the strip-shaped mask 31 may be conveyed in a roll-to-roll manner, so as to keep the mask 31 to move synchronously with the substrate 30 in the exposure region through a release and recovery process similar to that of the substrate 30. This will not be described herein again.

Optionally, the mask 31 is an endless mask, and the mask conveying module 3031 is configured to rotate the endless mask at the first speed.

In this embodiment, the endless mask 31 is connected end-to-end and can rotate in cycles, and by means of the endless mask 31, the pattern on the mask 31 can be used in cycles for exposure, which is conducive to improving the consistency of the exposure pattern, and the exposure device 303 has a more compact structure, which is conducive to improving the space utilization of the substrate treatment apparatus 300.

Optionally, the mask conveying module 3031 includes a first drive roller 3031a and a driven roller 3031b. The first drive roller 3031a rotates at the first speed as a linear velocity, and the first drive roller 3031a and the driven roller 3031b are disposed on the inside of the endless mask 31 to rotate the endless mask.

Specifically, the endless mask 31 is supported by the first drive roller 3031a and the driven roller 3031b provided on the inside to form a closed structure, and the first drive roller 3031a and the driven roller 3031b form a cyclic driving mechanism, so that the endless mask 31 can rotate in circles as the first drive roller 3031a and the driven roller 3031b rotate, and the endless mask 31 with the pattern can pass through the exposure region and then be rotated to the exposure region again.

In this embodiment, the mask conveying module 3031 rotates the mask 31 by means of the structure of the drive roller 3031a and the driven roller 3031b, and can control the movement conditions of the mask 31 by means of controlling the rotation speed and rotation direction of the drive roller 3031a and fix the movement path of the mask 31 by means of the driven roller 3031b, so as to achieve flexible control of the mask 31 to improve the flexibility of the exposure device 303, which is conducive to improving the treatment performance of the substrate treatment apparatus 300.

Optionally, the etching device 304 includes a conductive roller 3041, a first electrode 3042 and an etching tank 3043. The conductive roller 3041 and the first electrode 3042 are disposed in the etching tank 3043, and the etching tank 3043 holds an electrolyte solution. The conductive roller 3041 and the first electrode 3042 have opposite polarities, and the conductive roller 3041 comes into contact with the exposed substrate 30 and conveys the substrate 30 to the etching tank 3043 at the first speed.

Specifically, multiple first electrodes 3042 may be provided and disposed in the etching tank 3043 and close to the substrate 30. During the processing of the current collector, the conductive roller 3041 and the first electrode 3042 with opposite polarities form a cathode and an anode in a dielectric solution. In this case, the substrate 30 is a current collector, and the portions of the current collector that are not coated with photoresist will be etched so as to form a corresponding pattern or through hole.

In the embodiments of the present application, the etching device 304 uses an electrochemical etching method, and can quickly etch the substrate and ensure that the substrate is subjected to etching while traveling at a certain speed, so that the substrate does not need to stay in the etching device, and thus the etching device can cooperate with other devices to allow the substrate to always travel at the same feeding speed in the feeding direction, which facilitates integration of the etching device with other devices.

It should be understood that, in the embodiments of the present application, the electrochemical etching is taken as a specific example, but in some other embodiments, the etching device 304 may also use physical etching, dry etching, etc. to etch the substrate.

Although the present application has been described with reference to the preferred embodiments, various modifications can be made, and equivalents can be provided to substitute for the components thereof without departing from the scope of the present application. In particular, the technical features mentioned in the embodiments can be combined in any manner, provided that there is no structural conflict. The present application is not limited to the specific embodiments disclosed herein, but includes all the technical solutions that fall within the scope of the claims.

## Claims

1. A substrate treatment apparatus, **characterized by** comprising:
a coating device configured to coat a substrate, which is conveyed at a first speed in a feeding direction, with a material;
a drying device configured to receive the substrate, which is coated by means of the coating device, at the first speed and dry the material;
an exposure device configured to receive the substrate, which is dried by means of the drying device, at the first speed and continuously convey a mask at the first speed in the feeding direction, the mask being used for regional shading during exposure of the material by means of the exposure device, so that the material is subjected to continuous and regional exposure at the first speed by means of the exposure device; and
an etching device configured to receive the substrate, which is exposed by means of the exposure device, at the first speed and etch the material and a portion of the substrate in an unexposed region of the substrate.

2. The apparatus according to claim 1, **characterized by** further comprising:
a feeding device configured to convey the substrate at the first speed in the feeding direction.

3. The apparatus according to claim 1 or 2, **characterized by** further comprising:
a cleaning device configured to receive the substrate, which is etched by means of the etching device, at the first speed and clean the substrate.

4. The apparatus according to any one of claims 1-3, **characterized in that** the coating device comprises:
a first feeding module configured to allow the feeding direction in the coating device to be a vertical direction.

5. The apparatus according to claim 4, **characterized in that** the coating device performs coating by means of a gravure coating process.

6. The apparatus according to claim 4 or 5, **characterized in that** the substrate has a first surface and a second surface opposite to the first surface, and the coating device is configured to coat the first surface and the second surface with the material.

7. The apparatus according to any one of claims 1-6, **characterized in that** the drying device comprises: a plurality of heating tubes and a plurality of air knives arranged at intervals on two sides of the substrate in the feeding direction.

8. The apparatus according to any one of claims 1-7, **characterized in that** the exposure device comprises:
a mask conveying module configured to continuously convey the mask at the first speed in the feeding direction.

9. The apparatus according to claim 8, **characterized in that** the mask is an endless mask, and the mask conveying module is configured to rotate the endless mask at the first speed.

10. The apparatus according to claim 9, **characterized in that** the mask conveying module comprises:
a first drive roller and a driven roller, the first drive roller rotating at the first speed as a linear velocity, and the first drive roller and the driven roller being disposed on the inside of the endless mask to rotate the endless mask.

11. The apparatus according to any one of claims 1-10, **characterized in that** the etching device comprises:
a conductive roller, a first electrode and an etching tank, the conductive roller and the first electrode being disposed in the etching tank, and the etching tank holding an electrolyte solution, wherein the conductive roller and the first electrode have opposite polarities, and the conductive roller comes into contact with the exposed substrate and conveys the substrate to the etching tank at the first speed.

12. The apparatus according to claim 3, **characterized in that** the cleaning device comprises:
a spray rod and a cleaning tank, the spray rod being configured to spray a cleaning liquid to the etched substrate, and the washing tank being configured to collect and discharge a waste liquid after cleaning the substrate.
